# EUROPÄISCHE PATENTSCHRIFT

(11) **EP 3 417 300 B1**
(45) Veröffentlichungstag und Bekanntmachung des Hinweises auf die Patenterteilung: **08.04.2020**
(21) Anmeldenummer: 17703757.9
(22) Anmeldetag: 08.02.2017
(51) Int. Cl.: G01R 31/327, H02H 3/04

(54) **PRÜFGERÄT UND VERFAHREN ZUM PRÜFEN EINER STEUEREINHEIT EINER SCHALTVORRICHTUNG EINER SCHALTANLAGE**
TESTING DEVICE AND METHOD FOR TESTING A CONTROL UNIT OF A SWITCHING DEVICE OF A SWITCHGEAR INSTALLATION
APPAREIL DE TEST ET PROCÉDÉ POUR CONTRÔLER UNE UNITÉ DE COMMANDE D'UN DISPOSITIF DE COMMUTATION D'UN SYSTÈME DE COMMUTATION

(30) Priorität: 15.02.2016 AT 500942016
(43) Veröffentlichungstag der Anmeldung: 26.12.2018
(73) Patentinhaber: Omicron electronics GmbH, 6833 Klaus (AT)
(72) Erfinder: JOCHUM, Michael, 6844 Altach (AT); GEIGER, Stephan, 6830 Rankweil (AT); KÜNG, Rainer, 6741 Raggal (AT)
(74) Vertreter: Patentanwälte Pinter & Weiss OG
(86) Internationale Anmeldenummer: PCT/EP2017/052718
(87) Internationale Veröffentlichungsnummer: WO 2017/140547

(56) Entgegenhaltungen:
- EP-A2- 2 273 278
- DE-A1-102008 034 109
- US-A- 4 712 058
- US-A1- 2014 312 909

## Beschreibung

Die gegenständliche Erfindung betrifft ein Prüfgerät und ein Verfahren zum Prüfen einer Steuereinheit einer Schaltvorrichtung einer Schaltanlage wobei das Prüfgerät einen Signaleingang aufweist und wobei im Prüfgerät eine gesteuerte Stromsenke vorhanden ist, die mit dem Signaleingang verbunden ist. Ebenso betrifft die Erfindung die Verwendung des Prüfgeräts zum Prüfen einer Steuereinheit einer Schaltvorrichtung einer Schaltanlage.

Oftmals sind Geräte zur Prüfung von Steuereinheiten von elektrischen Schaltvorrichtungen notwendig. Speziell im Bereich der elektrischen Schutztechnik und elektrischen Energieversorgung ist die Prüfung der Funktion von Schaltvorrichtungen und deren Steuereinheiten wichtig und oftmals sogar vorgeschrieben. Beispielsweise sind in elektrischen Mittelspannungsnetzen an Masten montierte Schaltvorrichtungen oft mit elektro-magnetischen Aktuatoren ausgestattet und über Steuerverbindungen mit Steuereinheiten verbunden. Üblicherweise wird ein Prüfgerät verwendet, das die Schaltvorrichtung simulieren soll. Dazu wird die Schaltvorrichtung und die Steuerverbindung von der Steuereinheit getrennt und stattdessen ein Prüfgerät über ein Adapterkabel an die Steuereinheit angeschlossen, um deren Funktion zu prüfen. Das Prüfgerät muss dann entsprechende elektrische Signale erzeugen, die die Steuereinheit zu bestimmten Reaktionen anregen sollen. Die Reaktionen werden vom Prüfgerät erfasst und ausgewertet.

Steuereinheiten haben unter anderem die Funktion, über Steuerverbindungen kurzzeitig eine positive Spannung auf die Spule des Aktuators auszugeben und damit die Schaltvorrichtung zu öffnen. Zum Schließen der Schaltvorrichtung wird eine negative Spannung über die gleiche oder eine andere Steuerleitungen ausgegeben. Typischerweise werden Gleichspannungen im Bereich von 12-250V verwendet. Die Dauer der Spannungsimpulse liegt typischerweise im Bereich von 10ms bis 100ms und ist von der Ausgestaltung der Schaltvorrichtung abhängig. Um ein Schalten der Schaltvorrichtung zu ermöglichen, muss die Schaltvorrichtung, d.h. in erster Linie die angeschlossene Spule des magnetischen Aktuators, oftmals zuerst von der Steuereinheit erkannt werden, um beispielsweise eine defekte Steuerverbindung zu erkennen, bzw. um sicherzustellen, dass die Schaltvorrichtung angeschlossen ist. Diese Erkennung erfolgt über kurzzeitig ausgegebene Pulse durch die Steuereinheit, wobei die Pulse selbstverständlich so kurz sein müssen, dass die Schaltvorrichtung keine Schalthandlung auslöst. Durch Messung des rückfließenden Stroms wird auf die angeschlossene Last (also in erster Linie auf den Widerstand der Spule) geschlossen. Um den Zustand des Aktuators zu bestimmen, d.h. ob die Schaltvorrichtung betätigt oder nicht betätigt ist, ist es in manchen Steuereinheiten auch üblich, die Impedanz des magnetischen Aktuators kontinuierlich oder in Intervallen zu messen, da die Impedanz der Schaltvorrichtung vom Zustand des Aktuators abhängig ist.

Die US 2014/0312909 A1 offenbart eine Schaltung mit einer Stromsenke, die an einem Eingang angebracht sind und angesteuert wird, um einen Frittstrom zu verursachen und weiter eine Messung einer Spannung zu ermöglichen. Ein Spannungsmessmodul misst die dabei eingestellte Spannung, wobei der Frittstrom gänzlich von der Stromsenke aufgenommen wird und kein Strom vom Spannungsmessmodul selbst bezogen wird.

Es sind in der Regel Adapterkabel notwendig, um diese Steuerleitungen der Steuereinheit an den Messeingang eines Prüfgerätes anzuschließen. Diese Adapterkabel beinhalten oftmals eine zusätzliche Elektronik oder ein zusätzliche elektrische Beschaltung. Zumeist werden im Adapterkabel Widerstände verwendet, um die Impedanz der Spule des magnetischen Aktuators zu simulieren und damit der Steuereinheit eine angeschlossene Schaltvorrichtung zu suggerieren. Zudem sind in den Adapterkabeln Vorrichtungen notwendig, welche die an den Steuerleitungen anliegenden positiven und negativen Spannungen trennen und zu jeweils positiven Spannungen wandeln und separat (also über separate Leitungen) an das Prüfgerät weiterleiten. Diese entstehenden positiven Spannungen können also an das Prüfgerät an zwei unterschiedliche binäre Signaleingänge mit jeweils zwei Pins angelegt werden, woraufhin das Prüfgerät die Funktion der Steuereinheit prüfen kann.

Die bisher bekannte Lösung bedarf somit zusätzlicher Komponenten, um eine Prüfung der Steuereinheit zu ermöglichen. Die Herstellung von Adapterkabeln, die diese Komponenten beinhalten, wird dadurch komplexer, teurer und fehleranfällig. Weiters müssen unterschiedliche Adapterkabel mit unterschiedlichen elektrischen Eigenschaften verwendet werden, wenn Schaltvorrichtungen mit unterschiedlichen elektrischen Eigenschaften getestet werden. Außerdem müssen mehrere binäre Signaleingänge des Prüfgeräts belegt werden, was auch die eigentliche Verkabelung komplexer und fehleranfälliger macht.

Die Aufgabe der gegenständlichen Erfindung besteht somit darin, ausgehend vom oben beschriebenen Stand der Technik eine verbesserte Funktionsprüfung der Schaltvorrichtung durch ein Prüfgerät zu ermöglichen.

Diese Aufgabe wird gelöst, indem im Prüfgerät die gesteuerte vom Signaleingang einen Eingangsstrom abzweigt, um eine dynamisch einstellbare Eingangsimpedanz zu realisieren.

Da die Impedanz der Schaltvorrichtung erfindungsgemäß dynamisch durch die Eingangsimpedanz des Prüfgeräts simuliert werden kann, ist keine Notwendigkeit gegeben unterschiedliche Adapterkabel mit unterschiedlicher Elektronik zur Simulation der Impedanz unterschiedlicherer Schaltvorrichtungen zu verwenden. Die Herstellung von Adapterkabeln wird dadurch günstiger und einfacher. Zudem wird das Risiko von Komponentenfehlern im Adapterkabel minimiert.

Weiters sind selbst Schaltvorrichtungen, deren Impedanz vom Schaltzustand (Trip oder Close) abhängig ist, durch das Prüfgerät simulierbar. Im diesem Fall wird, sobald ein Steuersignal von der Steuereinheit an das Prüfgerät übermittelt wird, die Steuereinheit in gängiger Weise durch das Prüfgerät erkannt, und weiter der Strom der Stromsenke derart angepasst, dass sich die gewünschte Eingangsimpedanz im Kombination mit der anliegenden Eingangsspannung ergibt. Bekanntermaßen ergibt sich die Eingangsimpedanz als Quotient von Eingangsspannung und Eingangsstrom. Der Signaleingang des Prüfgeräts wird also entsprechend konfiguriert, um die Last in Form der Spule des Leistungsschalters zu simulieren. Somit können die erforderlichen Eingangsimpedanzen zur Simulation der Spulenimpedanz je nach Schalterzustand gesetzt und dynamisch verändert werden. Die gewünschte Last kann individuell eingestellt werden, somit können unterschiedlichste Steuereinheiten geprüft werden. Eine Änderung einer Komponente des Verbunds aus Steuereinheit und Schaltvorrichtung, beispielsweise auch eine durch Firmware-Upgrade bedingte höhere zu simulierende Last, kann einfach im Prüfgerät ohne hardwareseitige Änderung adaptiert werden. Um beispielsweise die Spulenerkennung sensibler zu gestalten, kann die minimal notwendige Impedanz der Schaltvorrichtung für eine positive Erkennung der angeschlossenen Schaltvorrichtung mittels Firmware-Upgrade geändert werden. Die Steuerung der Stromsenke kann beispielsweise durch eine Softwareeinstellung in einer Logikeinheit im Prüfgerät erfolgen.

Da die Impedanz der Schaltvorrichtung vom Prüfgerät korrekt abgebildet werden kann, sind somit jegliche Steuereinheiten, die wie eingangs beschrieben die Funktion oder den Anschluss der Schaltvorrichtung über die Impedanz eruieren wollen, durch das Prüfgerät unter uneingeschränkt prüfbar. Dazu können Adapterkabel ohne jegliche integrierte Elektronik verwendet werden.

Das erfindungsgemäße Prüfgerät kann zum Prüfen einer Steuereinheit einer Schaltvorrichtung einer Schaltanlage verwendet werden, indem das Prüfgerät die Schaltvorrichtung nachbildet. Dazu ist der Signaleingang des Prüfgeräts mit der Steuereinheit verbunden und es wird von der Steuereinheit ein Eingangssignal an den Signaleingang ausgegeben.

Durch die Verwendung des Prüfgeräts kann sich die Eingangsimpedanz durch den Eingangsstrom und die Eingangsspannung ergeben.

Vorteilhafterweise kann die gesteuerte Stromsenke mittels eines gesteuerten Regelkreises realisiert werden, in dem eine gesteuerte Spannungsquelle und ein Shunt vorhanden sind. Die Höhe des Eingangsstroms der Stromsenke kann vom einem über den Shunt fließenden Strom eingestellt wird, welcher wiederum von der gesteuerten Spannungsquelle eingestellt wird.

Die gegenständliche Erfindung wird nachfolgend unter Bezugnahme auf die Figuren 1 bis 3 näher erläutert, die beispielhaft, schematisch und nicht einschränkend vorteilhafte Ausgestaltungen der Erfindung zeigen. Dabei zeigt
Fig.1 einen Teil eines elektrischen Versorgungsnetzes,
Fig.2 das Versorgungsnetz mit getrennter Verbindung zwischen Schaltvorrichtung und Steuereinheit, die zur Prüfung an ein Prüfgerät angeschlossen ist, und
Fig.3 einen erfindungsgemäßen Schaltungsaufbau des Prüfgeräts.

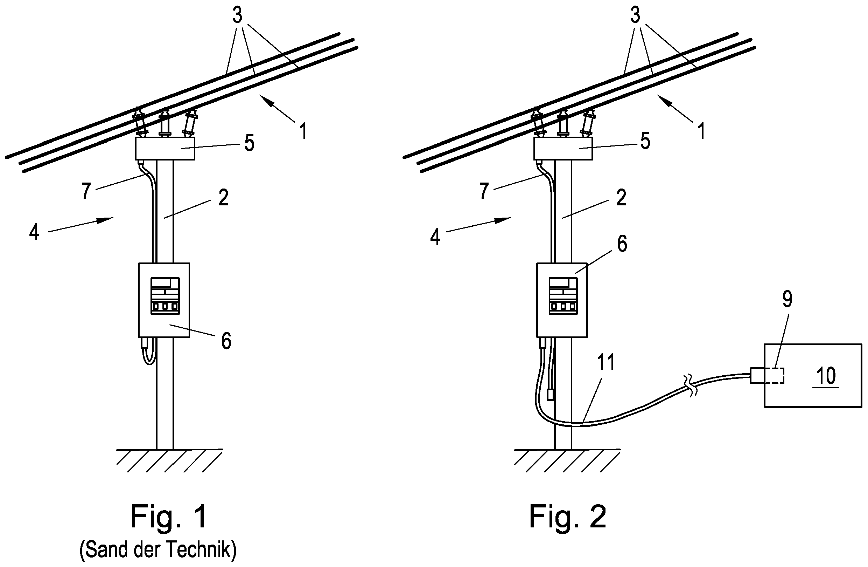

In Fig.1 ist ein Teil eines elektrischen Versorgungsnetzes 1 dargestellt, im gezeigten Ausführungsbeispiel eine 3-phasige Freileitung, deren Leitungen 3 in herkömmlicher Weise zwischen Masten 2 gespannt sind. Am Mast 2 ist als Sicherheitseinrichtung eine Schaltanlage 4 vorgesehen, die aus einer Schaltvorrichtung 5 und einer zugehörigen Steuereinheit 6 besteht. Die Schaltvorrichtung 5 ist beispielsweise in bekannter Weise ein Recloser oder ein Leistungsschalter in Form eines magnetischen Aktuators, der eine Spule beinhaltet. Die Schaltvorrichtung 5 ist in der Lage, durch eine von der Steuereinheit 6 ausgelöste Schalthandlung, zumindest eine der Leitungen 3 zu trennen oder zu verbinden. Die Erfindung ist aber natürlich nicht auf die Anwendung in einem elektrischen Versorgungsnetz 1 in Form einer Freileitung beschränkt, sondern kann in jeder Anlage zur Übertragung oder Verteilung von elektrischer Energie mit Sicherheitseinrichtungen in Form einer Schaltanlage 4 mit einer Schaltvorrichtung 5 und einer zugehörigen Steuereinheit 6 verwendet werden.

Die Schaltvorrichtung 5 ist hierzu mit einer Steuerverbindung 7 mit der Steuereinheit 6 verbunden. Die Steuerverbindung 7 umfasst hierzu in der Regel eine Anzahl von Steuerleitungen zur Übermittlung von Steuereingangsgrößen und Steuerausgangsgrößen. Durch Steuerausgangsgrößen werden typischerweise Schalthandlungen ausgelöst. Hier gibt es auf Seite der Steuereinheit 6, auf für jede Phase einzeln, oftmals separate Signalausgänge für ein Trip-Signal (also Öffnen der Schaltvorrichtung 5) und für ein Close-Signal (also Schließen der Schaltvorrichtung 5), es kann aber auch nur ein binärer Signaleingang für Trip und Close verwendet werden. Insbesondere relevant für die Erfindung sind dabei Steuerausgangsgrößen. Diese Steuerausgangsgrößen sind Signale, die von der Steuereinheit 6, z.B. in Reaktion auf die Steuereingangsgrößen, erzeugt werden und mit denen die Funktion der Schaltvorrichtung 5 gesteuert wird, beispielsweise eine Schalthandlung ausgelöst wird. Dabei wird beispielsweise von der Steuereinheit 6 als Steuerausgangsgröße über die Steuerleitungen 7 ein positiver Puls für das Trip-Signal, oder ein negativer Puls als Close-Signal ausgegeben.

Zum Prüfen der Schaltanlage 4 wird die Steuerverbindung 7 zwischen Schaltvorrichtung 5 und Steuereinheit 6 getrennt, wie in Fig.2 dargestellt. Es wäre auch möglich, dass die Schaltvorrichtung 5 vor der Prüfung gar nicht mit der Steuereinheit 6 verbunden ist, beispielsweise bei Erstinbetriebnahme. Dann würde das Trennen der Steuerverbindung 7 entfallen. Das ist recht häufig der Fall, da die Steuereinheiten 6 oft vor Installation parametriert und anschließend mit dem Prüfgerät 10 auf Funktion getestet werden, bevor diese "ins Feld" gebracht und installiert werden. Die Steuereinheit 6 wird zur Prüfung mit einem Adapterkabel 11 mit einem Prüfgerät 10 verbunden, das die Schaltvorrichtung 5 simuliert, um die ordnungsgemäße Funktion und Parametrierung der Steuereinheit 6 der Schaltanlage 4 prüfen zu können. Das Adapterkabel 11 wird mit einer Seite an den Signalausgang der Steuereinheit 6 und mit der anderen Seite an den Signaleingang 9 des Prüfgeräts 10 angeschlossen. Selbstverständlich können mit dem Adapterkabel 11 auch Signaleingänge der Steuereinheit 6 und Signalausgänge des Prüfgeräts 10 kontaktiert werden. Das Prüfgerät 10 dient somit dazu, die Schaltvorrichtung 5 nachzubilden bzw. zu simulieren.

Über den Signaleingang empfängt das Prüfgerät 10 Steuerausgangsgrößen der Steuereinheit 6, wobei Prüfgeräte 10 nach Stand der Technik in der Regel binäre Signaleingänge aufweisen. Das Prüfgerät 10 zur Nachbildung der Schaltvorrichtung 5 muss daher konfiguriert werden, um die in der Schaltvorrichtung 5 vorhandenen Signaleingänge und Signalausgänge nachbilden zu können. Wobei für eine Prüfung nicht unbedingt alle Signaleingänge oder Signalausgänge benötigt werden. Üblicherweise sind am Prüfgerät 10 je ein Signaleingang 9 für das Trip-Signal und je ein Signaleingang 9 für das Close-Signal vorhanden, wobei jeder Signaleingang 9 wiederum aus zwei Pins besteht. Hierzu wird in einer im Adapterkabel 11 untergebrachten Elektronik oder elektrischen Beschaltung das positive Steuersignal (z.B. Trip) oder negative Steuersignal (z.B. Close) aufgespalten und an jeweils einen binären Signaleingang 9 zugeführt. Dies kann jeweils als positives oder als negatives Steuersignal erfolgen, pro Signaleingang ist jedenfalls nur eine (positive oder negative) Schaltschwelle möglich. Dazu sind die Adapterkabel 11 üblicherweise mit Elektronik oder einer elektrischen Beschaltung versehen, was die Produktion der Adapterkabel 11 kostenintensiver macht und auch deren Robustheit negativ beeinflusst.

Zudem weist die Schaltvorrichtung 5 eine Impedanz auf, welche ebenso in der Elektronik bzw. der elektrischen Beschaltung des Adapterkabels 11, beispielsweise in Form von Widerständen, berücksichtigt werden muss. Somit sind für unterschiedliche Schaltvorrichtungen 5 mit unterschiedlichen Impedanzen unterschiedliche Adapterkabel 11 notwendig. Diese Impedanz ist beispielsweise bei Realisierung der Schaltvorrichtung 5 durch einen magnetisch betätigten Aktuator zudem abhängig von der Schalterstellung der Schaltvorrichtung 5. Das bedeutet, dass bei Simulierung der Schaltvorrichtung 5 durch das Prüfgerät 10 und das Adapterkabel 11 im laufenden Betrieb, sobald ein Schaltvorgang durch die Steuereinheit 6 ausgelöst wird, auch die veränderliche Impedanz durch das Prüfgerät 10 bzw. das Adapterkabel 11 berücksichtigt werden muss.

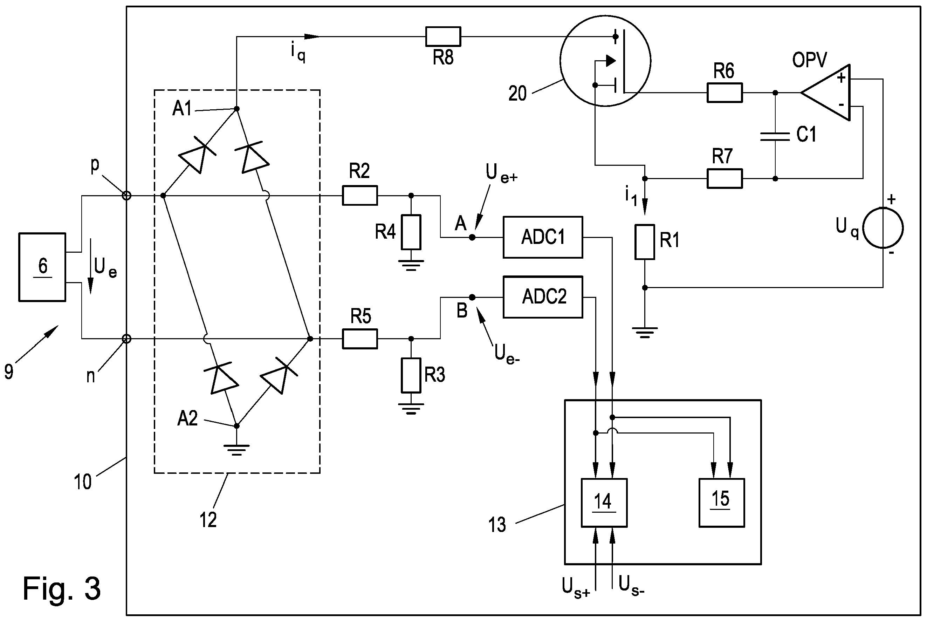

Erfindungsgemäß weist der Signaleingang 9 des Prüfgeräts 10 nun einen positiven Pin p und einen negativen Pin n auf und ist derart ausgelegt, dass ein Eingangssignal Uₑ zwischen dem positiven Pin p und dem negativen Pin n angelegt werden kann, wie in Fig.3 dargestellt. Weiter weist das Prüfgerät 10 eine Trenneinheit 12 auf, die mit dem positiven Pin p und dem negativen Pin n verbunden ist und ausgestaltet ist, vom Eingangssignal Uₑ einen positiven Signalanteil in Form einer positiven Spur Uₑ₊ zu trennen und an einem ersten Pin A auszugeben, bzw. intern zur Verfügung zu stellen, und vom Eingangssignal einen negativen Signalanteil in Form einer negative Spur Uₑ₋ zu trennen und an einem zweiten Pin B auszugegeben, bzw. intern zur Verfügung zu stellen.

Das erfindungsgemäße Prüfgerät 10 ermöglicht es somit, nur einen Signaleingang 9 für sowohl ein Trip-, als auch ein Close-Signal zu verwenden. Da der Signaleingang 9 ternär ausgestaltet ist, ist nur eine geringere Anzahl an Eingängen, als bei einer binären Ausgestaltung der Signaleingänge 9 notwendig.

Ein erfindungsgemäßes Prüfgerät 10 kann zum Prüfen einer Steuereinheit 6 einer Schaltvorrichtung 5 einer Schaltanlage 4 die Schaltvorrichtung 5 nachbilden, wobei der Signaleingang 9 des Prüfgeräts 10 mit der Steuereinheit 6 verbunden ist, z.B. über ein Adapterkabel 11, und von der Steuereinheit 6 ein Eingangssignal Uₑ an den Signaleingang 9 ausgegeben wird.

Weiters kann das Prüfgerät 10 eine Logikeinheit 13 aufweisen, die mit dem ersten Pin A und dem zweiten Pin B verbunden ist und die positive Spur Uₑ₊ und die negative Spur Uₑ₋ unabhängig voneinander verarbeitet.

Zudem kann das Prüfgerät 10 eine Vergleichseinheit 14 aufweisen, beispielsweise in der Logikeinheit 13, die die positive Spur Uₑ₊ mit einer vorgegebenen oder eingestellten positiven Schwelle U_{S+} und die negative Spur Uₑ₋ mit einer vorgegebenen oder eingestellten negativen Schwelle U_{S}- vergleicht.

Auch kann das Prüfgerät 10 eine Detektionseinheit 15, beispielsweise in der Logikeinheit 13, aufweisen, die die positive und/oder negative Flanken der positiven Spur Uₑ₊ und/oder der negativen Spur Uₑ₋ detektiert.

Ganz besonders vorteilhafte ist die Realisierung der Trenneinheit 12 durch einen Gleichrichter, wobei der erste Pin A mit einem ersten Eingangsanschluss des Gleichrichters und dem positiven Pin p verbunden ist und der zweite Pin B mit dem zweiten Eingangsanschluss des Gleichrichters und dem negativen Pin verbunden ist. Anders ausgedrückt fallen der erste Eingangsanschluss des Gleichrichters, der positive Pin p und der erste Pin A und der zweiten Eingangsanschluss des Gleichrichters, der negativen Pin und der zweite Pin B zusammen. Die Realisierung der Trenneinheit 12 in Form eines Gleichrichters bedeutet einen geringen schaltungstechnischen Aufwand.

Zudem kann ein erster Analog/Digital-Wandler ADC1 vorhanden sein, der mit dem ersten Pin A verbunden ist und die positive Spur Uₑ₊ digitalisiert und/oder ein zweiter Analog/DigitalWandler ADC2 vorhanden sein, der mit dem zweiten Pin B verbunden ist und die negative Spur Uₑ₋ digitalisiert. Das ermöglicht die digitale Verarbeitung der positive Spur Uₑ₊ und der negative Spur Uₑ₋ und die einfache Ausgestaltung der Vergleichseinheit 14 und der Detektionseinheit 15 als Software.

In Fig. 3 ist eine mögliche Ausgestaltung der Erfindung dargestellt. Am Signaleingang 9 liegt am positiven Pin p und am negativen Pin n eine Eingangsspannung Uₑ an, die von der Steuereinheit 6 über das Adapterkabel 11 geliefert wird. Eine Trenneinheit 12 ist beispielhaft in Form eines Gleichrichters mit dem positiven Pin p und dem negativen Pin n verbunden. Dabei sind der positive Pin p und der negativen Pin n mit der Eingangsseite des Gleichrichters verbunden.

Der Gleichrichter ist in der gezeigten Ausgestaltung als hinlänglich bekannter Brückengleichrichter mit Dioden ausgeführt, wobei auch andere Ausgestaltungen des Gleichrichters denkbar sind.

Durch den Abgriff des positiven Anteils der Eingangsspannung Uₑ am ersten Pin A des Gleichrichters, kann eine positive Spur Uₑ₊ der Eingangsspannung Uₑ abgetrennt werden. Durch den Abgriff des negativen Anteils der Eingangsspannung Uₑ am zweiten Pin B des Gleichrichters, kann eine negative Spur Uₑ₋ der Eingangsspannung Uₑ abgetrennt werden. Um die positive Spur Uₑ₊ und die negative Spur Uₑ₋ in Spannungen zu wandeln, die vom ersten Analog/Digital-Wandler ADC1 und vom zweiten Analog/Digital-Wandler ADC2 verarbeitet werden können, werden die positive Spur Uₑ₊ und die negative Spur Uₑ₋ jeweils mittels eines Spannungsteilers in Form der Widerstände R2 und R4, respektive R5 und R3 auf einen geringeren Spannungswert gewandelt. Die digitalisierten Werte der positiven Spur Uₑ₊ und der negativen Spur Uₑ₋ werden einer Logikeinheit 13 zugeführt, die in diesem Fall eine Vergleichseinheit 14 beinhaltet, und unabhängig voneinander verarbeitet. Die Vergleichseinheit 14 vergleicht die positive Spur Uₑ₊ bzw. die die negative Spur Uₑ₋ mit einer vorgegebenen positiven Schwelle U_{S+} bzw. einer vorgegebenen negativen Schwelle U_{S-}. Daraus kann auf ein durch die Steuereinheit 6 gesendetes Trip-, oder Close-Signal geschlossen werden. In der Logikeinheit 13 können digitale Filter realisiert werden. Ein großer Vorteil der digitalen Filterrealisierung sind die, im Betrieb je nach Anforderung unterschiedlich, einstellbaren Filterparameter. Es besteht natürlich auch die Möglichkeit analoge Filter vor den ADCs zu platzieren, jedoch mit dem Nachteil der fixen Parameter und des zusätzlichen Schaltungsaufwandes.

Die Realisierung der Trenneinheit 12 in Form eines Gleichrichters am Eingang hat schaltungstechnische Vorteile, da die Verwendung einer unipolaren Spannungsversorgung bzw. ADC Wandlung ermöglich wird und eine gesteuerte Stromquelle mittels eines MOSFET auf einfache Weise realisierbar ist.

Es wäre natürlich auch möglich den Signaleingang 9 bipolar ausführen und anschließend die positive Spur Uₑ₊ und die negative Spur Uₑ₋ in digitaler Weise aus der Eingangsspannung Uₑ zu erzeugen. Diese Lösung bringt jedoch gegenüber der zuvor geschilderten Ausgestaltung einige Nachteile mit sich: Die Realisierung der ADCs, insbesondere deren Spannungsversorgung ist aufwendiger und eine spannungsgesteuerte Stromquelle unter Verwendung nur einen MOSFET ist nicht möglich. Stattdessen wäre eine bipolare spannungsgesteuerte Stromquelle vonnöten, was schaltungstechnisch deutlich komplexer wäre. Eine mögliche Realisierung würde beispielsweise jeweils ein MOSFET mit n-Kanal und ein MOSFET mit p-Kanal umfassen. Diese Lösung ist somit nur in einer aufwendigen und komplexen Kabellösung realisierbar, da doppelt so viele (binäre) Eingänge und, wie erwähnt, zusätzlich einstellbare Impedanzen notwendig sind.

Der in Fig. 3 dargestellte Gleichrichter könnte auch mit hochohmig geschalteten Ausgangsanschlüssen A1, A2 des Gleichrichters betrieben werden, also beinahe im Leerlauf. Ein geschlossener Stromkreis muss jedoch in jedem Fall vorhanden sein, damit der Gleichrichter tatsächlich betrieben werden kann und somit die positiven und negativen Spuren getrennt werden können.

Um allerdings die Impedanz der Schaltvorrichtung 5 durch das Prüfgerät 10 in Form einer dynamisch einstellbaren Eingangsimpedanz Z des Prüfgeräts10 zu simulieren, kann im Prüfgerät 10 eine gesteuerte Stromsenke 20 vorhanden sein, die mit dem Signaleingang 9 verbunden ist, wobei die gesteuerte Stromsenke 20 vom Signaleingang 9 einen Eingangsstrom i_{q} abzweigt.

Ganz besonders vorteilhafterweise ist die gesteuerte Stromsenke 20 mittels eines gesteuerten Regelkreises realisiert, in dem eine gesteuerte Spannungsquelle U_{q} und ein auf ein Bezugspotential, z.B. Masse, gelegter Shunt R1 vorhanden sind. Die Höhe des Eingangsstroms I_{q} der gesteuerten Stromsenke 20 wird von einem über den Shunt R1 fließenden Strom i₁ eingestellt wird, wobei der Strom i₁ von der gesteuerten Spannungsquelle U_{q} eingestellt wird und in etwa dem Eingangsstrom i_{q} entspricht.

In Fig. 3 ist der Signaleingang 9 über die Trenneinheit 12, in diesem Fall der Gleichrichter, und den Widerstand R8, mit der gesteuerten Stromsenke 20, beispielsweise in Form eines n-Kanal-MOSFETS, verbunden. Der MOSFET als gesteuerte Stromsenke 20 bezieht über den Drain-Eingang von einem ersten Ausgang des Gleichrichters den Eingangsstrom i_{q}, welcher von der gesteuerten Spannungsquelle U_{q} eingestellt wird, der zweite Ausgang des Gleichrichters liegt auf Bezugspotential (hier Masse). Dazu ist die gesteuerte Spannungsquelle U_{q} mit dem nicht invertierenden Eingang eines OPV verbunden. Der invertierende Eingang des OVP ist über den Widerstand R7 mit dem ersten Anschluss des Shunts R1 verbunden, womit sich die Spannung der gesteuerten Spannungsquelle U_{q} am Shunt R1 einstellt, da der zweite Anschluss des Shunts R₁, sowie der negative Ausgang der Spannungsquelle U_{q} mit dem Bezugspotential (hier Masse) verbunden ist. Damit fließt über den Shunt R₁ ein Strom i₁, der in etwa dem über die gesteuerte Stromsenke 20 bezogenen Eingangsstrom i_{q} entspricht. Der erste Anschluss des Shunts R1 ist mit dem Source-Eingang S des MOSFET verbunden. Zwischen dem nicht invertierendem Eingang des OPV und dem Ausgang des OPVs ist ein Kondensator C1 geschaltet. Weiters ist der Ausgang des OPV über den Widerstand R6 mit dem Gate des MOSFET verbunden. Da der MOSFET vorzugsweise im Sättigungsbereich betrieben wird, wird der Eingangsstrom i_{q}, der dem Drainstrom des MOSFET entspricht, über die Drain-Source-Spannung, d.h. in weiterer Linie über die gesteuerte Spannungsquelle U_{q}, eingestellt.

Selbstverständlich kann die gesteuerte Stromsenke 20 alternativ auch beispielsweise mittels Bipolar Transistoren realisiert werden. Eine derartige Änderung der Ansteuerung würde jedoch eine verringerte Spannungsfestigkeit bedeuten

Der Eingangsschutzwiderstand R8 weist einen positiven Temperaturkoeffizienten auf. Bei zu großen Eingangsströmen dient der Eingangsschutzwiderstand R8 als reversible thermische Sicherung, d.h. der Wert des Eingangswiderstands R8 steigt mit erhöhtem Eingangsstrom iq womit die Stromsenke 20 vor Überströmen geschützt wird. Der Operationsverstärke OPV dient als P-Regler, wobei die am nicht invertierenden Eingang anliegende Eingangsspannung U_{q} am Shunt R1 ausgeregelt wird. Der Proportionalwiderstand R7 ergibt im Verhältnis zu R1 den proportional Anteil des durch die OPV -Schaltung realisierten P-Reglers. Der sich dabei einstellende Strom am Ausgang des Operationsverstärkers OPV ergibt sich aus dem Quotienten von Eingangsspannung U_{q} am nicht invertierenden Eingang des OPV und dem Widerstand des Shunts R1. Der Kondensator C1 dient der Stabilität des Reglers, indem er bei höheren Frequenzen die Verstärkung reduziert. Der Gate-Widerstand R6 dient zur Ansteuerung des MOSFET.

Ein erfindungsgemäßes Prüfgerät 10 kann somit dazu verwendet werden, die Eingangsimpedanz Z durch den einstellbaren Eingangsstrom i_{q} und die anliegende Eingangsspannung Uₑ einzustellen.

Dazu kann die gesteuerte Stromsenke 20 oder die die gesteuerte Stromsenke 20 steuernde gesteuerte Spannungsquelle U_{q} softwaremäßig angesteuert werden. Damit kann der vom Signaleingang 9 abgezweigte Eingangsstrom i_{q} eingestellt werden, der in Kombination mit der Eingangsspannung Uₑ die gewünschte Eingangsimpedanz Z ergibt. Die dynamisch einstellbare Eingangsimpedanz Z ermöglicht einerseits eine Simulation diverser Schaltvorrichtungen 5 mit einem Prüfgerät 10 ohne die Notwendigkeit unterschiedlicher Adapterkabel 11 (abgesehen von eventuell unterschiedlichen Steckverbindungen). Weiters kann eine vom Schaltzustand abhängige Impedanz der Schaltvorrichtung 5 berücksichtigt werden, da im laufenden Betrieb/Test des Prüfgeräts 10 die Eingangsimpedanz Z beliebig variiert werden kann.

## Patentansprüche

1. Prüfgerät zum Prüfen einer Steuereinheit (6) einer Schaltvorrichtung (5) einer elektrischen Schaltanlage (4), wobei das Prüfgerät (10) einen Signaleingang (9) aufweist, und wobei im Prüfgerät (10) eine gesteuerte Stromsenke (20) vorhanden ist, die mit dem Signaleingang (9) verbunden ist, **dadurch gekennzeichnet, dass** die gesteuerte Stromsenke (20) vom Signaleingang (9) einen Eingangsstrom (i_{q}) abzweigt, um eine dynamisch einstellbare Eingangsimpedanz (Z) zu realisieren.

2. Prüfgerät nach Anspruch 1, **dadurch gekennzeichnet, dass** die gesteuerte Stromsenke (20) mittels eines gesteuerten Regelkreises realisiert ist, in dem eine gesteuerte Spannungsquelle (U_{q}) und ein Shunt (R₁) vorhanden sind, wobei die Höhe des Eingangsstroms (20) der gesteuerten Stromsenke (20) vom einem über den Shunt (R₁) fließenden Strom (i₁) eingestellt wird, wobei der Strom (i₁) von der gesteuerten Spannungsquelle (U_{q}) eingestellt wird.

3. Verwendung eines Prüfgeräts nach Anspruch 1 oder 2, **dadurch gekennzeichnet, dass** zum Prüfen einer Steuereinheit (6) einer Schaltvorrichtung (5) einer Schaltanlage (4) das Prüfgerät (10) die Schaltvorrichtung (5) nachbildet, der Signaleingang (9) des Prüfgeräts mit der Steuereinheit (6) verbunden ist und von der Steuereinheit (6) ein Eingangssignal (Uₑ) an den Signaleingang (9) ausgegeben wird.

4. Verwendung eines Prüfgeräts nach Anspruch3, **dadurch gekennzeichnet, dass** die Impedanz (Z) sich durch den Eingangsstrom (i_{q}) und die Eingangsspannung (Uₑ) ergibt.

5. Verfahren zum Prüfen einer Steuereinheit (6) einer Schaltvorrichtung (5) einer Schaltanlage (4), wobei das Prüfgerät (10) einen Signaleingang (9) aufweist, an dem eine Eingangsspannung (Uₑ) angelegt werden kann, **dadurch gekennzeichnet, dass** im Prüfgerät (10) eine gesteuerte Stromsenke (20) vom Signaleingang (9) einen Eingangsstrom (i_{q}) abzweigt, und damit eine dynamisch einstellbare Eingangsimpedanz (Z) realisiert.

6. Verfahren nach Anspruch 5, **dadurch gekennzeichnet, dass** die gesteuerte Stromsenke (20) mittels eines gesteuerten Regelkreises realisiert ist, in dem eine gesteuerte Spannungsquelle (U_{q}) an einem Shunt (R₁) einen Strom (i₁) einstellt und der Strom (I₁) die Höhe des Eingangsstroms (i_{q}) der gesteuerten Stromsenke (20) steuert.

## Claims

1. A testing device for testing a control unit (6) of a switching device (5) of an electrical switchgear installation (4), wherein the testing device (10) has a signal input (9), and wherein in the testing device (10) a controlled current sink (20) is provided, which is connected to the signal input (9), **characterized in that** the controlled current sink (20) shunts an input current (i_{q}) from the signal input (9) in order to provide a dynamically adjustable input impedance (Z).

2. The testing device of claim 1, **characterized in that** the controlled current sink (20) is obtained by means of a controlled control circuit, in which a controlled voltage source (U_{q}) and a shunt (R₁) are present, wherein the magnitude of the input current (20) of the controlled current sink (20) is set by a current (i₁) flowing across the shunt (R₁), wherein the current (i₁) is set by the controlled voltage source (U_{q}).

3. Use of a testing device of claim 1 or 2, **characterized in that**, for testing a control unit (6) of a switching device (5) of a switchgear installation (4), the testing device (10) reproduces the switching device (5), the signal input (9) of the testing device is connected to the control unit (6) and the control unit (6) outputs an input signal (Uₑ) to the signal input (9).

4. The use of a testing device of claim 3, **characterized in that** the impedance (Z) is obtained through the input current (i_{q}) and the input voltage (Uₑ).

5. A method for testing a control unit (6) of a switching device (5) of a switchgear installation (4), wherein the testing device (10) has a signal input (9), to which an input voltage (Uₑ) may be applied, **characterized in that** in the testing device (10), a controlled current sink (20) shuts an input current (i_{q}) from the signal input (9) and thus provides a dynamically adjustable input impedance (Z).

6. The method of claim 5, **characterized in that** the controlled current sink (20) is obtained by means of a controlled control circuit, in which a controlled voltage source (U_{q}) sets a current (i₁) over a shunt (R₁) and the current (I₁) controls the magnitude of the input current (i_{q}) of the controlled current sink (20).

## Revendications

1. Dispositif de test pour tester une unité de commande (6) d'un dispositif de commutation (5) d'un système de commutation électrique (4), le dispositif de test (10) présentant une entrée de signal (9), et un récepteur de courant commandé (20) étant présent dans le dispositif de test (10), lequel récepteur est relié à l'entrée de signal (9), **caractérisé en ce que** le récepteur de courant commandé (20) prélève un courant d'entrée (i_{q}) de l'entrée de signal pour réaliser une impédance (Z) d'entrée pouvant être ajustée de manière dynamique.

2. Dispositif de test selon la revendication 1, **caractérisé en ce que** le récepteur de courant commandé (20) est réalisé au moyen d'un circuit de régulation commandé dans lequel une source de tension commandée (U_{q}) et un shunt (R₁) sont présents, la valeur du courant d'entrée (20) du récepteur de courant commandé (20) étant ajustée par un courant (ii) passant par le shunt, le courant (i₁) étant ajusté par la source de tension (U_{q}) commandée.

3. Utilisation d'un dispositif de test selon la revendication 1 ou 2, **caractérisé en ce que,** pour la vérification d'une unité de commande (6) d'un dispositif de commutation (5) d'un système de commutation (4), le dispositif de test (10) reproduit le dispositif de commutation (5), l'entrée de signal (9) du dispositif de test est reliée à l'unité de commande (6) et un signal d'entrée (Uₑ) est délivré à l'entrée de signal (9) par l'unité de commande (6).

4. Utilisation d'un dispositif de test selon la revendication 3, **caractérisée en ce que** l'impédance (Z) est donnée par le courant d'entrée (i_{q}) et la tension d'entrée (Uₑ).

5. Procédé pour tester une unité de commande (6) d'un dispositif de commutation (5) d'un système de commutation (4), dans lequel le dispositif de test (10) présente une entrée de signal (9) à laquelle une tension d'entrée (Uₑ) peut être appliquée, **caractérisé en ce qu'**un récepteur de courant commandé (20) prélève un courant d'entrée (i_{q}) de l'entrée de signal (9) dans le dispositif de test (10), et réalise ainsi une impédance (Z) d'entrée pouvant être ajustée de manière dynamique.

6. Procédé selon la revendication 5, **caractérisé en ce que** le récepteur de courant commandé (20) est réalisé au moyen d'un circuit de régulation commandé dans lequel une source de tension commandée (U_{q}) ajuste un courant (i₁) au niveau d'un shunt (R₁) et le courant (i₁) commande la valeur du courant d'entrée (20) du récepteur de courant commandé (20).
